# EUROPEAN PATENT SPECIFICATION

(11) **EP 4 276 926 B1**
(45) Date of publication and mention of the grant of the patent: **22.07.2026**
(21) Application number: 21917846.4
(22) Date of filing: 02.09.2021
(51) Int. Cl.: B41J 2/045, B41J 3/46, B41J 29/13, B41J 29/02, H10P 72/00

(54) **ENCLOSURE SYSTEM**
UMSCHLIESSUNGSSYSTEM
SYSTÈME D'ENCEINTE

(30) Priority: 07.01.2021 KR 20210001870
(43) Date of publication of application: 15.11.2023
(73) Proprietor: Unijet Co., Ltd., Seongnam-si, Gyeonggi-do 13203 (KR)
(72) Inventor: LEE, Sung Jin, Seoul 05788 (KR); CHA, Jae Jung, Yongin-si Gyeonggi-do 16892 (KR)
(74) Representative: Jung, Minkyu
(86) International application number: PCT/KR2021/011849
(87) International publication number: WO 2022/149684

(56) References cited:
- EP-B1- 2 973 676
- KR-A- 20040 110 862
- KR-A- 20040 110 862
- KR-A- 20130 009 597
- KR-A- 20140 139 192
- KR-A- 20140 139 192
- KR-A- 20160 060 868
- KR-A- 20180 041 891
- KR-A- 20190 070 541
- KR-B1- 101 831 313

## Description

### TECHNICAL FIELD

The present invention relates to an enclosure system, and more particularly, to an enclosure system which enables a worker to maintain equipment inside an enclosure while keeping a gas atmosphere inside the enclosure.

### BACKGROUND ART

When industrial inkjet equipment is used, inkjet head maintenance such as wiping a surface of an inkjet head or applying pressure to a nozzle in a poor state to eject ink for cleaning is required. The inkjet head maintenance is performed at regular intervals.

After the inkjet head maintenance is performed, a process of checking whether speed and straightness of ink drops ejected from the inkjet head are in a good state is performed.

As described above, the inkjet head requiring replacement is replaced with a new inkjet head through the inkjet head maintenance and checking of an operating state of the inkjet head.

A process of manufacturing an organic light emitting diode (OLED) and a quantum dot organic light emitting diode (QD-OLED) is performed in an inner sealed space of an enclosure in which an atmosphere is created with a special gas to minimize impurity particles that cause product defects.

The process is performed as the inkjet head is installed in the inner sealed space of the enclosure, and the inkjet head is replaced after the inner sealed space of the enclosure is replaced with an atmospheric environment through an antechamber connected to the outside to replace the inkjet head requiring replacement through maintenance with a new inkjet head.

In recent years, a display to which the organic light emitting diode or the quantum dot organic light emitting diode is applied gradually increases in size to **190.5** cm (75 inches) or more, and equipment for manufacturing the display is produced by using maximum 10th generation glass.

Due to this reason, the enclosure also gradually increases in size, and as described above, much time is required to create an atmosphere in the inner sealed space of the enclosure with a special gas for performing the process again after replacing the inner sealed space of the enclosure with the atmospheric environment.

For example, an atmosphere is formed in the enclosure with a special gas such as a high-purity nitrogen gas or helium gas, after an environment in which a worker may access is created as clean dry air (CDA) is supplied into the enclosure to discharge an existing gas in order to replace the inkjet head, the inkjet head is replaced by opening a door of the enclosure, and after the door of the enclosure is closed when replacement of the inkjet head is completed, a special gas is supplied into the enclosure to discharge existing CDA, thereby creating an original process atmosphere.

Specifically, in order to create the original process atmosphere, the high-purity special gas is supplied into the enclosure at 2000 L per minute so that moisture and oxygen are below 50 PPM, and this process requires at least 5 hours.

Also, depending on purposes, an additional process of reducing moisture and oxygen using an additional purifier is required to make an inner environment of the enclosure below 1 PPM, and this additional process requires about 3 hours.

As described above, the process of converting and returning the inner atmosphere of the enclosure for the inkjet head maintenance or the replacement of the inkjet head requires considerable time.

[Related art document] Korean Patent Publication No. 2019-0090064 (July 31, 2019)
KR 2016 0060868 A discloses an inject printing apparatus including a first chamber and a second chamber connected to each other. A third chamber outside the first chamber and the second chamber is provided for testing the head module of the ink ejection device, which can move between the second chamber and the third chamber.

KR 2004 0110862 A discloses a paste applicator and a control method thereof capable of efficiently replacing a nozzle in a paste applicator having a closed chamber. The device includes a chamber accommodating a syringe unit and an anti-chamber connected to the chamber through a door. A glove is provided to move the syringe unit in the chamber to the anti-chamber.

EP 2 973 676 B1 describes a particle-free environment for fabrication of OLED panels on a variety of substrates sizes and substrate materials. For accessing the interior of the gas enclosure assembly, gloves are attached to glove ports of the enclosure.

KR 2014 0139192 A describes a device for monitoring a substrate and a monitoring chamber including the same. The device includes a chamber accommodating a substrate and a front inspection unit mounted at a lower portion of the chamber surrounded by an inspection box. The front inspection unit is configured to reciprocate within the inspection box.

KR 101 831 313 B1 describes a pipe connection structure for connecting two pipelines which are detachably coupled to each other by mutual movement.

### DISCLOSURE OF THE INVENTION

### TECHNICAL PROBLEM

The present invention provides an enclosure system capable of increasing work stability and reducing maintenance time in such a manner that a worker maintains equipment inside the enclosure while keeping a gas atmosphere inside the enclosure when maintaining industrial equipment installed in the enclosure for manufacturing a large-size display in order to solve the problems of the related art.

### TECHNICAL SOLUTION

In order to solve the above-described technical problem, an embodiment of the present invention provides an enclosure system including: a process unit moving chamber including a first maintenance opening hole through which one side portion of a process unit is exposed and a second maintenance opening hole through which the other side portion of the process unit is exposed, the process unit moving chamber moving integrally with the process unit; a management unit moving chamber including a management opening hole through which a management portion of a management unit is exposed and moving integrally with the management unit; and a fixed chamber connected to a door installed at one side wall part of an enclosure to form a predetermined space, the fixed chamber including a docking opening hole extending toward the inside of the enclosure. Here, through movement of the process unit and the management unit, the process unit moving chamber and the management unit moving chamber come in close contact with each other to allow the first maintenance opening hole and the management opening hole to communicate with each other, the process unit moving chamber and the fixed chamber come in close contact to allow the second maintenance opening hole and the docking opening hole to communicate with each other, and thus the process unit moving chamber, the management unit moving chamber, and the fixed chamber form one sealed space.

Preferably, the process unit moving chamber may have a rectangular shape, the first maintenance opening hole may be formed in a bottom surface thereof, the second maintenance opening hole may be formed in one side surface thereof, the management unit moving chamber may have a rectangular shape, the management opening hole may be formed in a top surface thereof, the fixed chamber may have a rectangular shape, and the docking opening hole may be formed in a direction facing the second maintenance opening hole.

Preferably, the fixed chamber may include: an outer frame having an opened central portion and disposed in a space of the fixed chamber; a docking frame having an opened central portion and disposed in the enclosure; a plurality of connecting rods passing through the inside and outside of the enclosure to integrally connect the outer frame and the docking frame; a guide bushing which is disposed in the enclosure to allow the plurality of connecting rods to slide in a longitudinal direction and into which the plurality of connecting rods are inserted; a driving unit configured to provide driving force so that the plurality of connecting rods slide in the longitudinal direction; the docking opening hole formed in the enclosure in correspondence with an opening of the outer frame and an opening of the docking frame; and a flexible connecting pipe configured to connect the docking opening hole and the opening of the docking frame.

Preferably, a flange part may extend from one side surface of the process unit moving chamber, at least one guide hole may be formed in one of the flange part and a corresponding surface of the docking frame facing the flange part, and a guide pin inserted into the guide hole may be formed on the other.

Preferably, a first O-ring groove may be formed in one of an outer periphery of the first maintenance opening hole and an outer periphery of the management opening hole, into which a first O-ring is inserted, and a first O-ring sealing surface facing the first O-ring groove to compress the first O-ring may be formed on the other.

Preferably, a second O-ring groove may be formed in one of an outer periphery of the second maintenance opening hole and an outer periphery of the opening of the docking frame, into which a second O-ring is inserted, and a second O-ring sealing surface facing the second O-ring groove to compress the second O-ring may be formed on the other.

Preferably, a sensor unit configured to detect a pressure state and a gas state may be disposed on one of the process unit moving chamber, the management unit moving chamber, and the fixed chamber.

Preferably, a gas supply hole through which an atmosphere gas is supplied, an air supply hole through which clean dry air (CDA) is supplied, and an exhaust hole through which the atmosphere gas or the CDA is exhausted may be formed in one of the process unit moving chamber, the management unit moving chamber, and the fixed chamber.

Preferably, when a horizontal direction on a plane of the enclosure is an X-axis, a vertical direction on the plane of the enclosure is a Y-axis, and a height direction of the enclosure is a Z-axis, the process unit may be movable in an X-axis direction and a Z-axis direction, the management unit may be movable in a Y-axis direction and the Z-axis direction, in a state in which the process unit moving chamber is moved and aligned in correspondence with an X-axis coordinate of the management unit moving chamber, and the management unit moving chamber is moved and aligned in correspondence with a Y-axis coordinate of the process unit moving chamber, the process unit moving chamber and the management unit moving chamber may come in close contact with each other as at least one of the process unit moving chamber and the management unit moving chamber is moved in the Z-axis direction, and the process unit moving chamber may be aligned in correspondence with a Z-axis coordinate of the fixed chamber while maintaining the state in which the process unit moving chamber and the management unit moving chamber come in close contact with each other.

Preferably, when a horizontal direction on a plane of the enclosure is an X-axis, a vertical direction on the plane of the enclosure is a Y-axis, and a height direction of the enclosure is a Z-axis, the process unit may be movable in an X-axis direction and a Z-axis direction, the management unit may be movable in a Y-axis direction and the Z-axis direction, and in a state in which the process unit moving chamber is moved and aligned in correspondence with an X-axis coordinate of the management unit moving chamber and a Z-axis coordinate of the fixed chamber, and the management unit moving chamber is moved and aligned in correspondence with a Y-axis coordinate of the process unit moving chamber, the process unit moving chamber and the management unit moving chamber may come in close contact with each other as the management unit moving chamber is moved in the Z-axis direction.

Preferably, the management unit disposed in the management unit moving chamber may include at least one vision inspection device of a maintenance vision inspection device for maintaining the process unit and an operation checking vision inspection device for inspecting an operation state of the process unit.

### ADVANTAGEOUS EFFECTS

The above-described present invention has the advantage of increasing the work stability and reducing the maintenance time by enabling the worker to maintain the equipment inside the enclosure while keeping the gas atmosphere inside the enclosure when maintaining the industrial equipment installed inside the enclosure for manufacturing the large-size display.

The object of the present invention is not limited to the aforesaid, but other objects not described herein will be clearly understood by those skilled in the art from descriptions below.

### BRIEF DESCRIPTION OF THE DRAWINGS

FIG. 1 is a perspective view illustrating an enclosure system according to an embodiment of the present invention.
FIG. 2 is a perspective view illustrating industrial equipment installed inside the enclosure system according to an embodiment of the present invention.
FIG. 3 is a perspective view illustrating a component of a fixed chamber of the enclosure system according to an embodiment of the present invention.
FIG. 4 is a perspective view illustrating a state in which one sealed space is formed by a process unit moving chamber, a management unit moving chamber, and a fixed chamber of the enclosure system according to an embodiment of the present invention.
FIG. 5 is an exploded perspective view of FIG. 4.

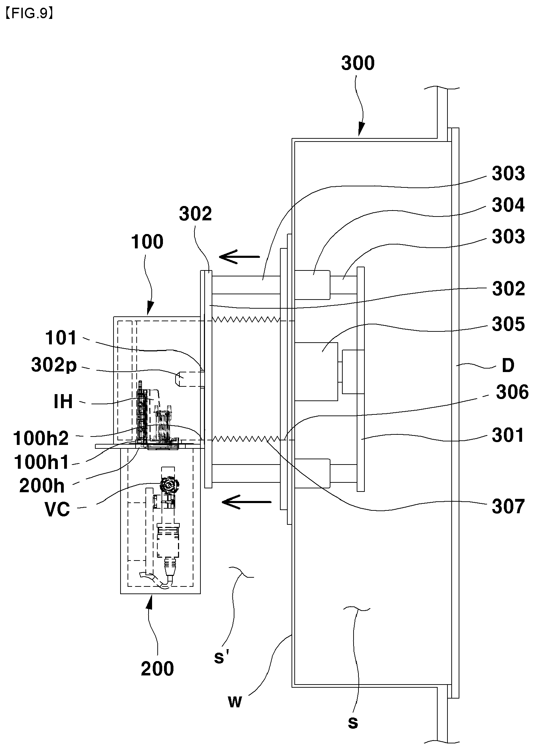

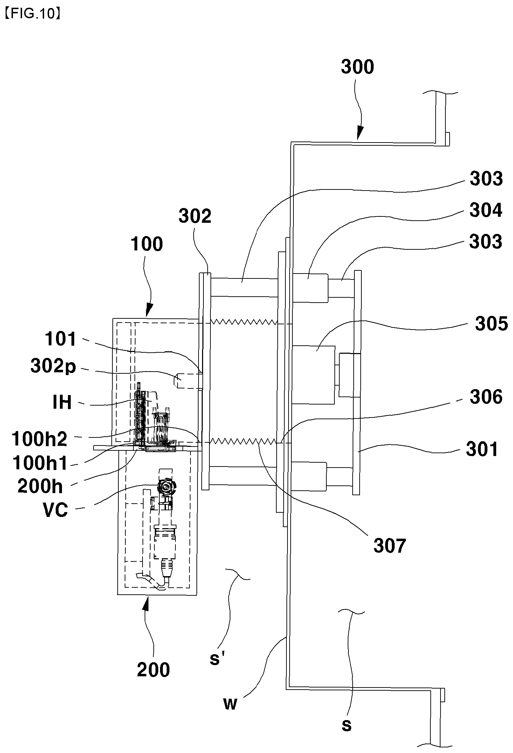

FIGS. 6 to 10 are views for explaining an operation of the process unit moving chamber, the management unit moving chamber, and the fixed chamber of the enclosure system according to an embodiment of the present invention.

### MODE FOR CARRYING OUT THE INVENTION

The present invention may be carried out in various embodiments without departing from the technical ideas or primary features. Therefore, the embodiments of the present invention are merely illustrative, but should not be limitedly interpreted. However, the scope of the invention is defined by the appended claims.

It will be understood that although the terms of first and second are used herein to describe various elements, these elements should not be limited by these terms.

The terms are only used to distinguish one component from other components. For example, a first element referred to as a first element in one embodiment can be referred to as a second element in another embodiment.

As used herein, the term and/or includes any and all combinations of one or more of the associated listed items.

It will also be understood that when an element is referred to as being '"connected to" or "engaged with" another element, it can be directly connected to the other element, or intervening elements may also be present.

It will also be understood that when an element is referred to as being 'directly connected to' another element, there is no intervening elements.

In the following description, the technical terms are used only for explaining a specific exemplary embodiment while not limiting the present invention. The terms of a singular form may include plural forms unless referred to the contrary.

The meaning of 'include' or 'comprise' specifies a property, a number, a step, a process, an element, a component, or a combination thereof in the specification but does not exclude other properties, numbers, steps, processes, elements, components, or combinations thereof.

Unless terms used in the present disclosure are defined differently, the terms may be construed as meaning known to those skilled in the art.

Terms such as terms that are generally used and have been in dictionaries should be construed as having meanings matched with contextual meanings in the art. In this description, unless defined clearly, terms are not ideally, excessively construed as formal meanings.

Hereinafter, embodiments disclosed in this specification is described with reference to the accompanying drawings, and the same or corresponding components are given with the same drawing number regardless of reference number, and their duplicated description will be omitted.

Moreover, detailed descriptions related to well-known functions or configurations will be ruled out in order not to unnecessarily obscure subject matters of the present invention.

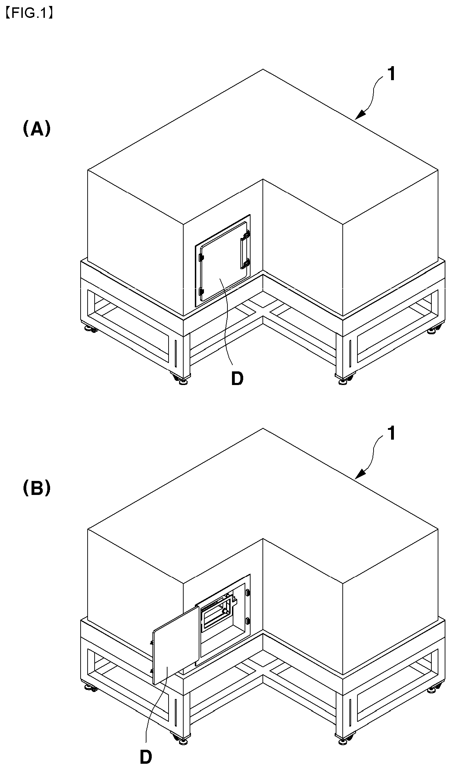

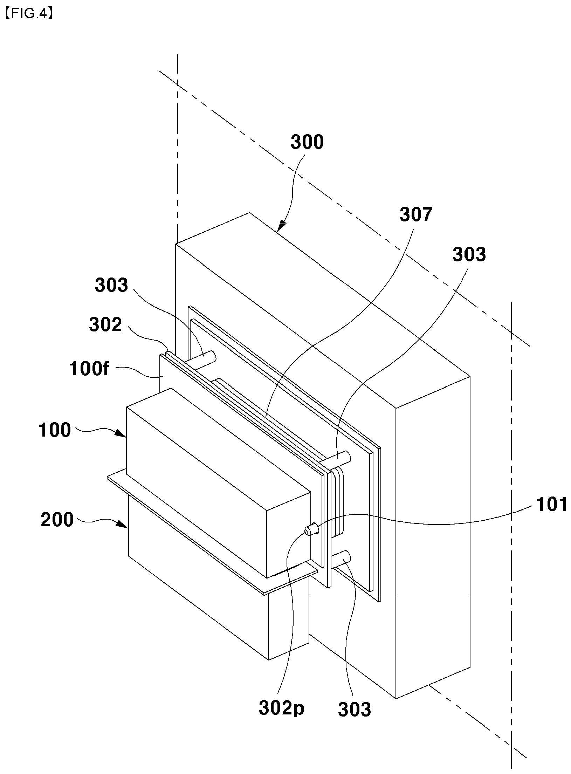

As illustrated in FIGS. 1 to 5, an enclosure system including an enclosure 1 for creating a specific process environment according to an embodiment of the present invention includes a process unit moving chamber 100, a management unit moving chamber 200, and a fixed chamber 300.

The process unit moving chamber 100 has a first maintenance opening hole 100h1 through which one side portion of a process unit IH is exposed and a second maintenance opening hole 100h2 through which the other portion of the process unit is exposed.

The management unit moving chamber 200 has a management opening hole 200h through which a management part of a management unit VC is exposed.

The fixed chamber 300 is connected to a door D disposed on one side wall part W of the enclosure 1 to form a predetermined space s and has a docking opening hole 306 formed toward an inner space s' of the enclosure 1.

The process unit IH and the management unit VC may be installed to move in the inner space s' of the enclosure 1, and through movement of the process unit IH and the management unit VC, the process unit moving chamber 100, the management unit moving chamber 200, and the fixed chamber 300 may form one sealed space. Hereinafter, each component will be described in detail.

In the enclosure system of the embodiment, the process unit IH may be an inkjet head module IH, and the management unit VC may include at least one vision inspection device of a maintenance vision inspection device for checking and maintaining a state of a nozzle of the inkjet head module IH and an operation checking vision inspection device for inspecting an ink drop ejected from the nozzle of the inkjet head module IH.

Hereinafter, a case in which the process unit includes the inkjet head module IH, and the management unit includes the vision inspection device VC will be described as an example.

In addition to the inkjet head module IH and the vision inspection device VC described above, the process unit and the management unit may include other devices constituting various industrial equipment.

Firstly, the process unit moving chamber 100 will be described.

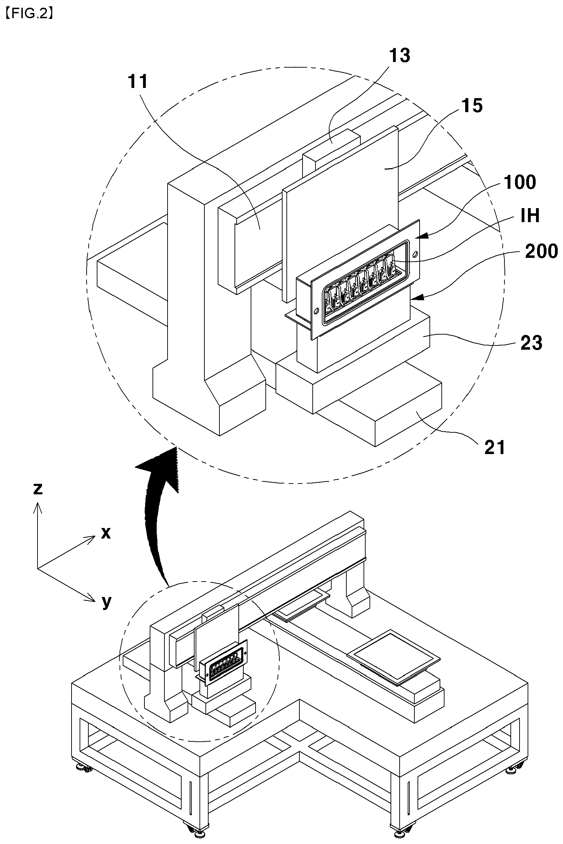

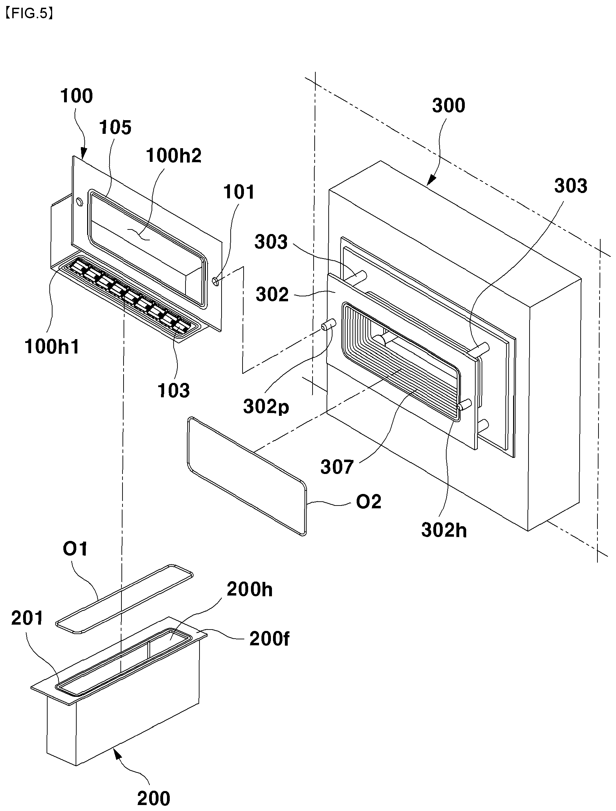

As illustrated in FIGS. 2 and 5, the process unit moving chamber 100 may surround the inkjet head module IH to move integrally with the inkjet head module IH when the inkjet head module IH is moved.

Specifically, as illustrated in FIG. 2, when a horizontal direction on a plane of the enclosure 1 is an X-axis, a vertical direction on the plane of the enclosure 1 is a Y-axis, and a height direction of the enclosure 1 is a Z-axis, a Z-axis rail part 13 may slide-move along an X-axis rail part 11 in an X-axis direction, a moving block 15 may slide-move along the Z-axis rail part 13 in a Z-axis direction, and the process unit moving chamber 100 and the inkjet head module IH may be installed on the moving block 15 to slide-move along the X-axis direction or the Z-axis direction.

The process unit moving chamber 100 has an approximately rectangular shape, a first maintenance opening hole 100h1 through which a nozzle portion of the inkjet head module IH is exposed is formed in a bottom surface thereof, and a second maintenance opening hole 100h2 through which a side portion of the inkjet head module IH is exposed is formed in one side surface thereof.

As illustrated in FIG. 5, the second maintenance opening hole 100h2 may be formed in a side portion of the process unit moving chamber 100 corresponding to a direction in which a plurality of heads of the inkjet head module IH are arranged.

A flange part 100f extends from one side surface of the process unit moving chamber 100 in which the second maintenance opening hole 100h2 is formed, and a guide hole 101 is formed on each of both side surfaces of the flange part 100f.

The guide hole 101 that is for docking with a docking frame 302 of the fixed chamber 300 will be additionally described when the fixed chamber 300 is described.

A first O-ring sealing surface 103 is formed on an outer periphery of the first maintenance opening hole 100h1, and a second O-ring sealing surface 105 is formed on an outer periphery of the second maintenance opening hole 100h2. The first O-ring sealing surface 103 is a portion compressing a first O-ring O1 when the process unit moving chamber 100 and the management unit moving chamber 200 come in close contact with each other, and the second O-ring sealing surface 105 is a portion compressing a second O-ring O2 when the process unit moving chamber 100 and the fixed chamber come in close contact with each other.

According to the above-described configuration of the process unit moving chamber 100, the process unit moving chamber 100 may slide-move integrally with the inkjet head module IH when the inkjet head module IH is slide-moved in the X-axis or the Z-axis in a state in which the process unit moving chamber 100 surrounds the rest portion except for one side portion and a lower portion of the inkjet head module IH.

Next, the management unit moving chamber 200 will be described.

As illustrated in FIGS. 2 and 5, the management unit moving chamber 200 may surround at least one vision inspection device VC to move integrally with the vision inspection device VC when the vision inspection device VC is moved.

Specifically, as illustrated in FIG. 2, as a Z-axis rail block 23 may slide-move along the Y-axis rail part 21 in the Y-axis direction, and the management unit moving chamber 200 may be elevated in the Z-axis direction by an elevation unit (not shown) disposed on the Z-axis rail block 23, the management unit moving chamber 200 may slide-move in the Y-axis direction or the Z-axis direction.

The management unit moving chamber 200 has an approximately rectangular shape, and the management opening hole 200h through which a portion facing a camera of a management portion of the vision inspection device VC is exposed is formed in a top surface thereof.

A flange part 200f may extend from a top surface of the management unit moving chamber 200 in which the management opening hole 200h is formed, and a first O-ring groove 201 is formed and inserted into an outer periphery of the management opening hole 200h on the flange part 200f.

The first O-ring groove 201 has a depth less than a diameter of the first O-ring O1, and the first O-ring O1 inserted into the first O-ring groove 201 is compressed by the first O-ring sealing surface 103 when the management unit moving chamber 200 and the process unit moving chamber 100 comes in close contact with each other.

That is, a sealed state may be formed as an upper portion of the management unit moving chamber 200 and a lower portion of the process unit moving chamber 100 come in close contact with each other in such a manner that the first O-ring sealing surface 103 formed on an outer periphery of the first maintenance opening hole 100h1 formed in a bottom surface of the process unit moving chamber 100 contacts the first O-ring O1 inserted into the first O-ring groove 201.

According to the above-described configuration of the management unit moving chamber 200, the management unit moving chamber 200 may slide-move integrally with the vision inspection device VC when the vision inspection device VC is slide-moved in the Y-axis and Z-axis in a state in which the management unit moving chamber 200 surrounds the rest portion except for an upper portion of the vision inspection device VC.

Next, the fixed chamber 300 will be described.

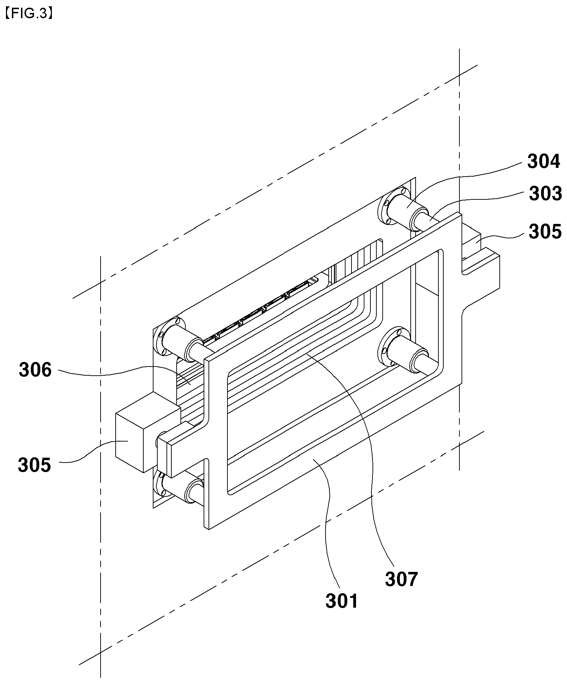

As illustrated in FIGS. 3 or 5, the fixed chamber 300 is connected to the door D installed on the one side wall part W of the enclosure 1 to have a predetermined space s having an approximately rectangular shape.

In the embodiment, the fixed chamber 300 includes all components described below instead of indicating only the space s.

Specifically, the fixed chamber 300 includes an outer frame 301, a docking frame 302, a plurality of connecting rods 303, a guide bushing 304, a driving unit 305, a docking opening hole 306, and a flexible connecting pipe 307.

The outer frame 301 that is a rectangular frame having a rectangular opening in a central portion thereof is disposed in the rectangular shaped space of the fixed chamber 300, and the docking frame 302 that is a rectangular frame having a rectangular opening in a central portion thereof is disposed in the inner space s' of the enclosure 1. The outer frame 301 and the docking frame 302 may have substantially similar shapes.

A guide pin 302p inserted into the guide hole 101 is formed on a corresponding surface of the docking frame 302 facing the flange part 100f formed on one side surface of the process unit moving chamber 100. Thus, when the process unit moving chamber 100 and the fixed chamber 300 come in close contact with each other, mutual movement thereof may be guided by the guide hole 101 and the guide pin 302p.

As a second O-ring groove 302h is formed on the corresponding surface of the docking frame 302 facing the flange part 100f formed on one side surface of the process unit moving chamber 100, the second O-ring O2 is inserted thereto.

The second O-ring groove 302h has a depth less than a diameter of the second O-ring O2, and the second O-ring O2 inserted into the second O-ring groove 302h is compressed by the second O-ring sealing surface 105 when the process unit moving chamber 100 and the fixed chamber 300 come in close contact with each other.

That is, a sealed state may be formed as one side surface of the process unit moving chamber 100 and a corresponding portion of the fixed chamber 300 come in close contact with each other in such a manner that the second O-ring sealing surface 105 formed on an outer periphery of the second maintenance opening hole 100h2 formed in one side surface of the process unit moving chamber 100 contacts the second O-ring O2 inserted into the second O-ring groove 302h.

The plurality of connecting rods 303 that are members connecting integrally each corner portion of the outer frame 301 and the docking frame 302 so that the outer frame 301 and the docking frame 302 are parallel to each other and maintain a constant interval therebetween pass through the inner space s' of the enclosure 1 and the space s of the fixed chamber 300 through the guide bushing 304.

The guide bushing 304 may be disposed on the wall part W of the enclosure 1 so that the plurality of the connecting rods 303 slide-move along a longitudinal direction, and the plurality of the connecting rods 303 may repeatedly perform linear movement in the longitudinal direction by the guide bushing 304.

The guide bushing 304 may repeatedly perform linear movement by the driving unit 305, and the driving unit 305 may be disposed on an outer side of the wall part W of the enclosure 1 and connected to the outer frame 301. For example, the driving unit 305 may include various types of driving devices such as a motor such as a linear motor and a screw motor and a cylinder such as a pneumatic cylinder and a hydraulic cylinder.

Thus, when the outer frame 301 is moved close to the wall part W of the enclosure W by driving of the driving unit 305, the docking frame 302 connected through the plurality of connecting rods 303 is moved in the same direction as the outer frame 301.

Also, when the outer frame 301 is spaced apart from the wall part W of the enclosure 1 by the driving of the driving unit 305, the docking frame 302 connected through the plurality of the connecting rods 303 is moved in the same direction as the outer frame 301.

The docking opening hole 306 that is a hole formed toward the inner space s' of the enclosure 1 in the space formed by the fixed chamber 300 may be formed in a direction in which the docking opening hole 306 faces the second maintenance opening hole 100h2 of the process unit moving chamber 100.

Also, the docking opening hole 306 may have a rectangular shape corresponding to an opening of the outer frame 301 and an opening of the docking frame 302.

All of the central rectangular opening of the outer frame 301, the central rectangular opening of the docking frame 302, and the rectangular docking opening hole 306 are arranged in a row.

The flexible connecting pipe 307 that is a portion for connecting the docking opening hole 306 and the opening of the docking frame 302 may include a connecting pipe made of a flexible material such as rubber or a metal connecting pipe having a bellows shape.

According to the above-described configuration of the fixed chamber 300, the fixed chamber 300 may be connected to the portion in which the door D of the enclosure is installed to form a predetermined space s and selectively docked with the process unit moving chamber 100.

Although not shown in the drawing, a sensor unit for detecting a pressure state and a gas state may be disposed on one of the process unit moving chamber 100, the management unit moving chamber 200, and the fixed chamber 300.

Also, although not shown in the drawing, a gas supply hole for supplying an atmospheric gas, an air supply for supplying clean dry air (CDA), and an exhaust hole for exhausting the atmospheric gas or the CDA may be defined in one of the process unit moving chamber 100, the management unit moving chamber 200, and the fixed chamber 300.

As described above, the enclosure system including the process unit moving chamber 100, the management unit moving chamber 200, and the fixed chamber 300 according to an embodiment of the present invention is configured such that the first maintenance opening hole 100h1 and the management opening hole 200h communicate with each other as the process unit moving chamber 100 and the management unit moving chamber 200 come in close contact with each other by movement of the inkjet head module IH and the vision inspection device VC, and the process unit moving chamber 100, the management unit moving chamber 200, and the fixed chamber 300 form one sealed space as the process unit moving chamber 100 and the fixed chamber 300 come in close contact with each other to allow the second maintenance opening hole 100h and the docking opening hole 306 to communicate with each other. Operations of the process unit moving chamber 100, the management unit moving chamber 200, and the fixed chamber 300 will be described in detail.

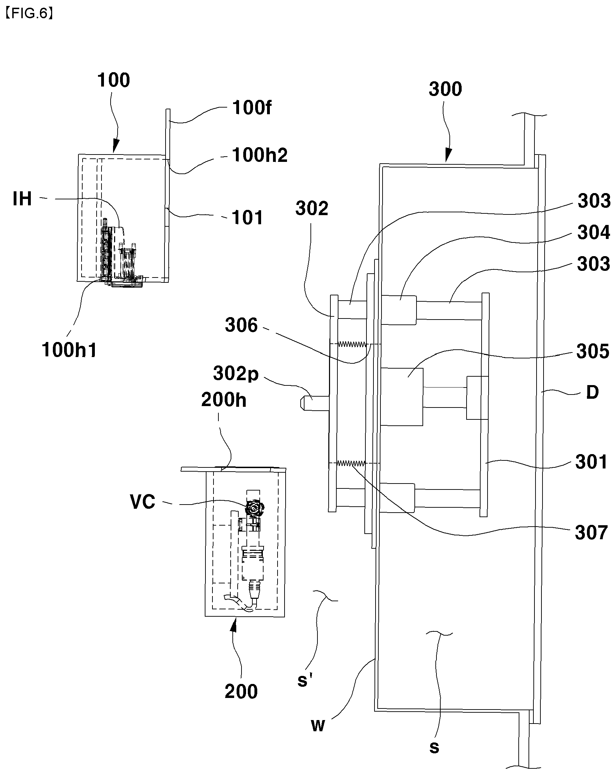

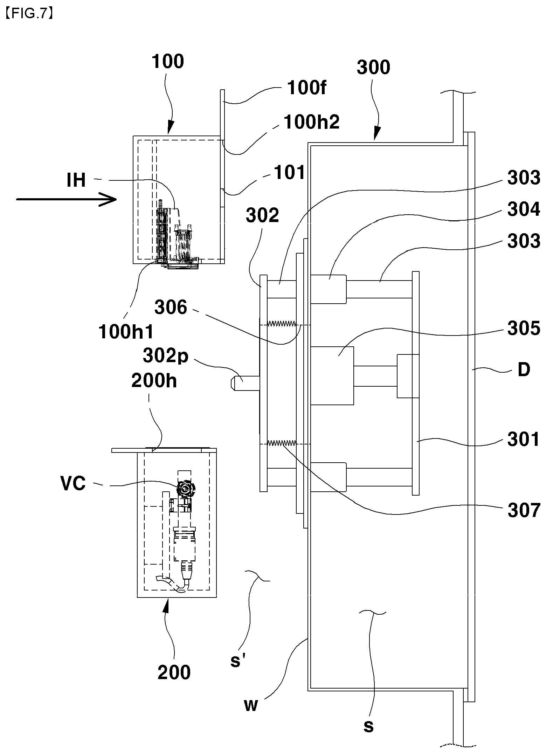

First, the process unit moving chamber 100 is moved and aligned in correspondence with an X-axis coordinate of the management unit moving chamber 200 to convert a state in FIG. 6 into a state in FIG. 7.

Thereafter, the management unit moving chamber 200 is moved and aligned in correspondence with a Y-axis coordinate of the process unit moving chamber 100.

A movement order of the process unit moving chamber 100 and the management unit moving chamber 200 may be changed.

Through the above-described process, the X and Y coordinates of process unit moving chamber 100 and the X and Y coordinates of the management unit moving chamber 200 may be matched and aligned.

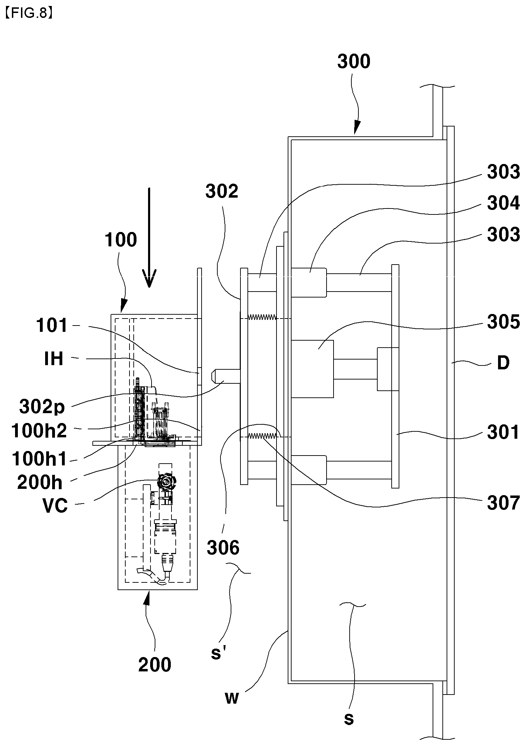

Thereafter, as illustrated in FIG. 8, as at least one of the process unit moving chamber 100 and the management unit moving chamber 200 is moved in the Z-axis direction, the process unit moving chamber 100 and the management unit moving chamber 200 come into close contact with each other.

Thereafter, while the process unit moving chamber 100 and the management unit moving chamber 200 maintain a close contact state, the process unit moving chamber 100 is aligned in correspondence with a Z-axis coordinate of the fixed chamber 300.

As described above, in a state in which the process unit moving chamber 100 and the management unit moving chamber 200 come into close contact with each other, and the process unit moving chamber 100 is aligned to the fixed chamber 300, the driving unit 305 is driven so that the outer frame 301 is moved close to the wall part W of the enclosure 1, and through this, the docking frame 302 and the process unit moving chamber 100 come into close contact with each other.

Through the above-described process, as the first maintenance opening hole 100h1 and the management opening hole 200h communicate with each other as the process unit moving chamber 100 and the management unit moving chamber 200 come into close contact with each other, and the second maintenance opening hole 100h2 and the docking opening hole 306 communicate with each other as the process unit moving chamber 100 and the fixed chamber 300 come into close contact with each other, one sealed space may be formed by the process unit moving chamber 100, the management unit moving chamber 200, and the fixed chamber 300.

In a state in which one sealed space is formed by the process unit moving chamber 100, the management unit moving chamber 200, and the fixed chamber 300, as the CDA is supplied through the air supply hole to discharge the atmosphere gas through the exhaust hole while detecting a pressure state and a gas state in the sealed space, an environment in which a worker is able to work is created.

When it is checked that the environment in which a worker is able to work is created, the worker may perform maintenance or replacement of the inkjet head module IH by opening the door D of the enclosure 1 to approach hands into the sealed space through the central rectangular opening of the outer frame 301, the central rectangular opening of the docking frame 302, and the rectangular docking opening hole 306.

When the work of the worker is completed, as the door D of the enclosure 1 is closed, and the atmosphere gas is supplied through the gas supply hole to discharge the CDA, the original process environment is created.

In addition to the above-described operations of the process unit moving chamber 100, the management unit moving chamber 200, and the fixed chamber 300, the method for forming one sealed space by the process unit moving chamber 100, the management unit moving chamber 200, and the fixed chamber 300 may be variously changed. For example, the process unit moving chamber 100 may be moved and aligned in correspondence with the X-axis coordinate of the management unit moving chamber 200 and the Z-axis coordinate of the fixed chamber 300, and in a state in which the management unit moving chamber 200 is moved and aligned in correspondence with the Y-axis coordinate of the process unit moving chamber 100, the process unit moving chamber 100 and the management unit moving chamber 200 may come in close contact with each other as the management unit moving chamber 200 is moved in the Z-axis direction, and then the docking frame 302 and the process unit moving chamber 100 may come in close contact with each other.

The above-disclosed subject matter is to be considered illustrative, and not restrictive, and the scope of the present invention is defined by the appended claims.

## Claims

1. An enclosure system comprising:
a process unit moving chamber (100) comprising a first maintenance opening hole (100h1) through which one side portion of a process unit (IH) is exposed and a second maintenance opening hole (100h2) through which the other side portion of the process unit (IH) is exposed, the process unit moving chamber (100) moving integrally with the process unit (IH);
a management unit moving chamber (200) comprising a management opening hole (200h) through which a management portion of a management unit (VC) is exposed and moving integrally with the management unit; and
a fixed chamber (300) connected to a door (D) installed at one side wall part (W) of an enclosure (1) to form a predetermined space (s), the fixed chamber (300) comprising a docking opening hole (306) extending toward the inside of the enclosure (1),
wherein through movement of the process unit (IH) and the management unit (VC),
the process unit moving chamber (100) and the management unit moving chamber (200) come in close contact with each other to allow the first maintenance opening hole (100h1) and the management opening hole (200h) to communicate with each other,
the process unit moving chamber (100) and the fixed chamber (300) come in close contact to allow the second maintenance opening hole (100h2) and the docking opening hole (306) to communicate with each other, and thus the process unit moving chamber (100), the management unit moving chamber (200), and the fixed chamber (300) form one sealed space.

2. The enclosure system of claim 1, wherein the process unit moving chamber (100) has a rectangular shape, the first maintenance opening hole (100h1) is formed in a bottom surface thereof, and the second maintenance opening hole (100h2) is formed in one side surface thereof,
the management unit moving chamber (200) has a rectangular shape, and the management opening hole (200h) is formed in a top surface thereof, and
the fixed chamber (300) has a rectangular shape, and the docking opening hole (306) is formed in a direction facing the second maintenance opening hole (100h2).

3. The enclosure system of claim 2, wherein the fixed chamber (300) comprises:
an outer frame (301) having an opened central portion and disposed in a space of the fixed chamber (300);
a docking frame (302) having an opened central portion and disposed in the enclosure (1);
a plurality of connecting rods (303) passing through the inside and outside of the enclosure (1) to integrally connect the outer frame (301) and the docking frame (302);
a guide bushing (304) which is disposed in the enclosure (1) to allow the plurality of connecting rods (303) to slide in a longitudinal direction and into which the plurality of connecting rods (303) are inserted;
a driving unit (305) configured to provide driving force so that the plurality of connecting rods (303) slide in the longitudinal direction;
the docking opening hole (306) formed in the enclosure (1) in correspondence with an opening of the outer frame (301) and an opening of the docking frame (302); and
a flexible connecting pipe (307) configured to connect the docking opening hole (306) and the opening of the docking frame (302).

4. The enclosure system of claim 3, wherein a flange part (100f) extends from one side surface of the process unit moving chamber (100), and
at least one guide hole (101) is formed in one of the flange part (100f) and a corresponding surface of the docking frame (302) facing the flange part (100f), and a guide pin (302p) inserted into the guide hole (101) is formed on the other.

5. The enclosure system of claim 3, wherein a first O-ring groove (201) is formed in one of an outer periphery of the first maintenance opening hole (100h1) and an outer periphery of the management opening hole (200h), into which a first O-ring is inserted, and a first O-ring sealing surface (103) facing the first O-ring groove to compress the first O-ring is formed on the other.

6. The enclosure system of claim 3, wherein a second O-ring groove (302h) is formed in one of an outer periphery of the second maintenance opening hole (100h2) and an outer periphery of the opening of the docking frame (302), into which a second O-ring is inserted, and a second O-ring sealing surface (105) facing the second O-ring groove to compress the second O-ring is formed on the other.

7. The enclosure system of claim 1, wherein a sensor unit configured to detect a pressure state and a gas state is disposed on one of the process unit moving chamber (100), the management unit moving chamber (200), and the fixed chamber.

8. The enclosure system of claim 1, wherein a gas supply hole through which an atmosphere gas is supplied, an air supply hole through which clean dry air (CDA) is supplied, and an exhaust hole through which the atmosphere gas or the CDA is exhausted are formed in one of the process unit moving chamber (100), the management unit moving chamber (200), and the fixed chamber (300).

9. The enclosure system of claim 1, wherein when a horizontal direction on a plane of the enclosure (1) is an X-axis, a vertical direction on the plane of the enclosure (1) is a Y-axis, and a height direction of the enclosure (1) is a Z-axis,
the process unit (IH) is movable in an X-axis direction and a Z-axis direction, and the management unit (VC) is movable in a Y-axis direction and the Z-axis direction,
in a state in which the process unit moving chamber (100) is moved and aligned in correspondence with an X-axis coordinate of the management unit moving chamber (200), and the management unit moving chamber (200) is moved and aligned in correspondence with a Y-axis coordinate of the process unit moving chamber (100), the process unit moving chamber (100) and the management unit moving chamber (200) come in close contact with each other as at least one of the process unit moving chamber (100) and the management unit moving chamber (200) is moved in the Z-axis direction, and
the process unit moving chamber (100) is aligned in correspondence with a Z-axis coordinate of the fixed chamber (300) while maintaining the state in which the process unit moving chamber (100) and the management unit moving chamber (200) come in close contact with each other.

10. The enclosure system of claim 1, wherein when a horizontal direction on a plane of the enclosure is an X-axis, a vertical direction on the plane of the enclosure is a Y-axis, and a height direction of the enclosure is a Z-axis,
the process unit (IH) is movable in an X-axis direction and a Z-axis direction, and the management unit (VC) is movable in a Y-axis direction and the Z-axis direction, and
in a state in which the process unit moving chamber (100) is moved and aligned in correspondence with an X-axis coordinate of the management unit moving chamber (200) and a Z-axis coordinate of the fixed chamber (300), and the management unit moving chamber (200) is moved and aligned in correspondence with a Y-axis coordinate of the process unit moving chamber (100),
the process unit moving chamber (100) and the management unit moving chamber (200) come in close contact with each other as the management unit moving chamber (200) is moved in the Z-axis direction.

11. The enclosure system of claim 1, wherein the management unit (VC) disposed in the management unit moving chamber (200) comprises at least one vision inspection device of a maintenance vision inspection device for maintaining the process unit (IH) and an operation checking vision inspection device for inspecting an operation state of the process unit (IH).

## Patentansprüche

1. Gehäusesystem, umfassend:
eine Prozesseinheitsbewegungskammer (100), die ein erstes Wartungsöffnungsloch (100h1), durch das ein Seitenabschnitt einer Prozesseinheit (IH) freigelegt ist, und ein zweites Wartungsöffnungsloch (100h2) umfasst, durch das der andere Seitenabschnitt der Prozesseinheit (IH) freigelegt ist, wobei sich die Prozesseinheitsbewegungskammer (100) einheitlich mit der Prozesseinheit (IH) bewegt;
eine Verwaltungseinheitsbewegungskammer (200), die ein Verwaltungsöffnungsloch (200h) umfasst, durch das ein Verwaltungsabschnitt einer Verwaltungseinheit (VC) freigelegt ist, und die sich einheitlich mit der Verwaltungseinheit bewegt; und
eine feststehende Kammer (300), die mit einer Tür (D) verbunden ist, die an einem Seitenwandteil (W) eines Gehäuses (1) installiert ist, um einen vorbestimmten Raum (s) zu bilden, wobei die feststehende Kammer (300) ein Andocköffnungsloch (306) umfasst, das sich zur Innenseite des Gehäuses (1) erstreckt,
wobei durch Bewegung der Prozesseinheit (IH) und der Verwaltungseinheit (VC)
die Prozesseinheitsbewegungskammer (100) und die Verwaltungseinheitsbewegungskammer (200) in engen Kontakt miteinander kommen, um es dem ersten Wartungsöffnungsloch (100h1) und dem Verwaltungsöffnungsloch (200h) zu ermöglichen, miteinander in Verbindung zu stehen,
die Prozesseinheitsbewegungskammer (100) und die feststehende Kammer (300) in engen Kontakt kommen, um es dem zweiten Wartungsöffnungsloch (100h2) und dem Andocköffnungsloch (306) zu ermöglichen, miteinander in Verbindung zu stehen, und somit die Prozesseinheitsbewegungskammer (100), die Verwaltungseinheitsbewegungskammer (200) und die feststehende Kammer (300) einen abgedichteten Raum bilden.

2. Gehäusesystem nach Anspruch 1, wobei die Prozesseinheitsbewegungskammer (100) eine rechteckige Form aufweist, das erste Wartungsöffnungsloch (100h1) in deren Bodenfläche ausgebildet ist und das zweite Wartungsöffnungsloch (100h2) in deren Seitenfläche ausgebildet ist,
die Verwaltungseinheitsbewegungskammer (200) eine rechteckige Form aufweist und das Verwaltungsöffnungsloch (200h) in deren oberer Fläche ausgebildet ist, und
die feststehende Kammer (300) eine rechteckige Form aufweist und das Andocköffnungsloch (306) in einer dem zweiten Wartungsöffnungsloch (100h2) zugewandten Richtung ausgebildet ist.

3. Gehäusesystem nach Anspruch 2, wobei die feststehende Kammer (300) umfasst:
einen äußeren Rahmen (301), der einen geöffneten zentralen Abschnitt aufweist und in einem Raum der feststehenden Kammer (300) angeordnet ist;
einen Andockrahmen (302), der einen geöffneten zentralen Abschnitt aufweist und im Gehäuse (1) angeordnet ist;
eine Mehrzahl von Verbindungsstangen (303), die durch die Innen- und Außenseite des Gehäuses (1) verlaufen, um den äußeren Rahmen (301) und den Andockrahmen (302) zu einer Einheit zu verbinden;
eine Führungsbuchse (304), die im Gehäuse (1) angeordnet ist, um es der Mehrzahl von Verbindungsstangen (303) zu ermöglichen, in einer Längsrichtung zu gleiten, und in welche die Mehrzahl von Verbindungsstangen (303) eingesetzt ist;
eine Antriebseinheit (305), die dazu eingerichtet ist, eine Antriebskraft bereitzustellen, sodass die Mehrzahl von Verbindungsstangen (303) in der Längsrichtung gleitet;
das Andocköffnungsloch (306), das im Gehäuse (1) in Übereinstimmung mit einer Öffnung des äußeren Rahmens (301) und einer Öffnung des Andockrahmens (302) ausgebildet ist; und
ein flexibles Verbindungsrohr (307), das dazu eingerichtet ist, das Andocköffnungsloch (306) und die Öffnung des Andockrahmens (302) zu verbinden.

4. Gehäusesystem nach Anspruch 3, wobei sich ein Flanschteil (100f) von einer Seitenfläche der Prozesseinheitsbewegungskammer (100) erstreckt, und
mindestens ein Führungsloch (101) entweder im Flanschteil (100f) oder in einer dem Flanschteil (100f) zugewandten entsprechenden Fläche des Andockrahmens (302) ausgebildet ist, und ein in das Führungsloch (101) eingesetzter Führungsstift (302p) am jeweils anderen ausgebildet ist.

5. Gehäusesystem nach Anspruch 3, wobei eine erste O-Ring-Nut (201) entweder an einem Außenumfang des ersten Wartungsöffnungslochs (100h1) oder an einem Außenumfang des Verwaltungsöffnungslochs (200h) ausgebildet ist, in die ein erster O-Ring eingesetzt ist, und eine der ersten O-Ring-Nut zugewandte erste O-Ring-Dichtfläche (103) zum Komprimieren des ersten O-Rings am jeweils anderen ausgebildet ist.

6. Gehäusesystem nach Anspruch 3, wobei eine zweite O-Ring-Nut (302h) entweder an einem Außenumfang des zweiten Wartungsöffnungslochs (100h2) oder an einem Außenumfang der Öffnung des Andockrahmens (302) ausgebildet ist, in die ein zweiter O-Ring eingesetzt ist, und eine der zweiten O-Ring-Nut zugewandte zweite O-Ring-Dichtfläche (105) zum Komprimieren des zweiten O-Rings am jeweils anderen ausgebildet ist.

7. Gehäusesystem nach Anspruch 1, wobei eine Sensoreinheit, die dazu eingerichtet ist, einen Druckzustand und einen Gaszustand zu erfassen, an einer der Prozesseinheitsbewegungskammer (100), der Verwaltungseinheitsbewegungskammer (200) und der feststehenden Kammer angeordnet ist.

8. Gehäusesystem nach Anspruch 1, wobei ein Gaszufuhrloch, durch welches ein Atmosphärengas zugeführt wird, ein Luftzufuhrloch, durch welches saubere, trockene Luft, CDA, zugeführt wird, und ein Auslassloch, durch welches das Atmosphärengas oder die CDA abgeführt wird, in einer der Prozesseinheitsbewegungskammer (100), der Verwaltungseinheitsbewegungskammer (200) und der feststehenden Kammer (300) ausgebildet sind.

9. Gehäusesystem nach Anspruch 1, wobei, wenn eine horizontale Richtung auf einer Ebene des Gehäuses (1) eine X-Achse ist, eine vertikale Richtung auf der Ebene des Gehäuses (1) eine Y-Achse ist und eine Höhenrichtung des Gehäuses (1) eine Z-Achse ist,
die Prozesseinheit (IH) in einer X-Achsen-Richtung und einer Z-Achsen-Richtung beweglich ist, und die Verwaltungseinheit (VC) in einer Y-Achsen-Richtung und der Z-Achsen-Richtung beweglich ist,
in einem Zustand, in dem die Prozesseinheitsbewegungskammer (100) in Übereinstimmung mit einer X-Achsen-Koordinate der Verwaltungseinheitsbewegungskammer (200) bewegt und ausgerichtet ist, und die Verwaltungseinheitsbewegungskammer (200) in Übereinstimmung mit einer Y-Achsen-Koordinate der Prozesseinheitsbewegungskammer (100) bewegt und ausgerichtet ist, die Prozesseinheitsbewegungskammer (100) und die Verwaltungseinheitsbewegungskammer (200) in engen Kontakt miteinander kommen, wenn mindestens eine der Prozesseinheitsbewegungskammer (100) und der Verwaltungseinheitsbewegungskammer (200) in der Z-Achsen-Richtung bewegt wird, und
die Prozesseinheitsbewegungskammer (100) in Übereinstimmung mit einer Z-Achsen-Koordinate der feststehenden Kammer (300) ausgerichtet ist, während der Zustand beibehalten wird, in dem die Prozesseinheitsbewegungskammer (100) und die Verwaltungseinheitsbewegungskammer (200) in engen Kontakt miteinander kommen.

10. Gehäusesystem nach Anspruch 1, wobei, wenn eine horizontale Richtung auf einer Ebene des Gehäuses eine X-Achse ist, eine vertikale Richtung auf der Ebene des Gehäuses eine Y-Achse ist und eine Höhenrichtung des Gehäuses eine Z-Achse ist,
die Prozesseinheit (IH) in einer X-Achsen-Richtung und einer Z-Achsen-Richtung beweglich ist, und die Verwaltungseinheit (VC) in einer Y-Achsen-Richtung und der Z-Achsen-Richtung beweglich ist, und
in einem Zustand, in dem die Prozesseinheitsbewegungskammer (100) in Übereinstimmung mit einer X-Achsen-Koordinate der Verwaltungseinheitsbewegungskammer (200) und einer Z-Achsen-Koordinate der feststehenden Kammer (300) bewegt und ausgerichtet ist, und die Verwaltungseinheitsbewegungskammer (200) in Übereinstimmung mit einer Y-Achsen-Koordinate der Prozesseinheitsbewegungskammer (100) bewegt und ausgerichtet ist,
die Prozesseinheitsbewegungskammer (100) und die Verwaltungseinheitsbewegungskammer (200) in engen Kontakt miteinander kommen, wenn die Verwaltungseinheitsbewegungskammer (200) in der Z-Achsen-Richtung bewegt wird.

11. Gehäusesystem nach Anspruch 1, wobei die in der Verwaltungseinheitsbewegungskammer (200) angeordnete Verwaltungseinheit (VC) mindestens eine Sichtprüfvorrichtung aus einer Wartungssichtprüfvorrichtung zur Wartung der Prozesseinheit (IH) und einer Betriebsprüfungssichtprüfvorrichtung zur Inspektion eines Betriebszustands der Prozesseinheit (IH) umfasst.

## Revendications

1. Système d'enceinte comprenant:
une chambre mobile d'unité de traitement (100) comprenant une première ouverture d'entretien (100h1) à travers laquelle une partie latérale d'une unité de traitement (IH) est apparente et une deuxième ouverture d'entretien (100h2) à travers laquelle l'autre partie latérale de l'unité de traitement (IH) est apparente, la chambre mobile d'unité de traitement (100) se déplaçant d'un seul tenant avec l'unité de traitement (IH);
une chambre mobile d'unité de gestion (200) comprenant une ouverture de gestion (200h) à travers laquelle une partie de gestion d'une unité de gestion (VC) est apparente, et se déplaçant d'un seul tenant avec l'unité de gestion; et
une chambre fixe (300) reliée à une porte (D) installée sur une partie de paroi latérale (W) d'une enceinte (1) permettant de former un espace prédéterminé (s), la chambre fixe (300) comportant un orifice d'amarrage (306) s'étendant vers l'intérieur de l'enceinte (1),
dans lequel, le déplacement de l'unité de traitement (IH) et de l'unité de gestion (VC),
amène la chambre mobile d'unité de traitement (100) et la chambre mobile d'unité de gestion (200) à entrer en contact étroit l'une avec l'autre afin de mettre en communication la première ouverture d'entretien (100h1) et l'ouverture de gestion (200h),
la chambre mobile d'unité de traitement (100) et la chambre fixe (300) entrent en contact étroit afin de mettre en communication la deuxième ouverture d'entretien (100h2) et l'ouverture d'amarrage (306), la chambre mobile d'unité de traitement (100), la chambre mobile d'unité de gestion (200) et la chambre fixe (300) forment ainsi un espace étanche.

2. Système d'enceinte selon la revendication 1, dans lequel la chambre mobile d'unité de traitement (100) se présente sous forme rectangulaire, la première ouverture d'entretien (100h1) est pratiquée dans sa face inférieure, et la deuxième ouverture d'entretien (100h2) est formée dans sa face latérale,
la chambre mobile d'unité de gestion (200) se présente sous forme rectangulaire, et l'ouverture de gestion (200h) est formée dans sa face supérieure, et
la chambre fixe (300) se présente sous forme rectangulaire, et l'ouverture d'amarrage (306) est pratiquée dans une direction tournée vers la deuxième ouverture d'entretien (100h2).

3. Système d'enceinte selon la revendication 2, dans lequel la chambre fixe (300) comprend:
un cadre extérieur (301) présentant une partie centrale ouverte et est disposé dans un espace de la chambre fixe (300);
un cadre d'amarrage (302) comportant une partie centrale ouverte et disposé dans l'enceinte (1);
une pluralité de bielles (303) traversant l'intérieur et l'extérieur de l'enceinte (1) afin de relier d'un seul tenant le cadre extérieur (301) et le cadre d'amarrage (302);
une douille de guidage (304) disposée dans le boîtier (1) pour permettre à la pluralité de bielles (303) de coulisser dans le sens longitudinal et dans laquelle est insérée la pluralité de bielles (303);
une unité d'entraînement (305) conçue pour fournir une force motrice permettant à la pluralité de bielles (303) de coulisser dans le sens longitudinal;
l'ouverture d'amarrage (306) pratiqué dans l'enceinte (1) en correspondance avec une ouverture du cadre extérieur (301) et une ouverture du cadre d'amarrage (302); et
un tuyau de raccordement flexible (307) conçu pour relier l'orifice d'amarrage (306) et l'ouverture du cadre d'amarrage (302).

4. Système d'enceinte selon la revendication 3, dans lequel une partie rebord (100f) s'étend à partir d'une surface latérale de la chambre mobile d'unité de traitement (100), et
au moins un trou de guidage (101) est pratiqué dans l'une parmi la partie rebord (100f), une surface correspondante du cadre d'amarrage (302) faisant face à la partie rebord (100f), et une tige de guidage (302p) insérée dans le trou de guidage (101) est formée sur l'autre surface.

5. Système d'enceinte selon la revendication 3, dans lequel une première rainure de joint torique (201) est formée dans l'une parmi la périphérie extérieure de la première ouverture d'entretien (100h1), la périphérie extérieure de l'ouverture de gestion (200h), dans laquelle est inséré un premier joint torique, et une première surface d'étanchéité de joint torique (103) faisant face à la rainure de joint torique afin de comprimer le premier joint torique, est formée sur l'autre périphérie.

6. Système d'enceinte selon la revendication 3, dans lequel une deuxième rainure de joint torique (201) est formée dans l'une parmi la périphérie extérieure de la deuxième ouverture d'entretien (100h2), la périphérie extérieure de l'ouverture du cadre d'amarrage (302), dans laquelle est inséré un deuxième joint torique, et une deuxième surface d'étanchéité de joint torique (105) faisant face à la rainure de joint torique afin de comprimer le premier joint torique, est formée sur l'autre périphérie.

7. Système d'enceinte selon la revendication 1, dans lequel une unité de détection conçue pour détecter un état de pression et un état gazeux est disposée sur l'une parmi la chambre mobile d'unité de traitement (100), la chambre mobile d'unité de gestion (200) et la chambre fixe.

8. Système d'enceinte selon la revendication 1, dans lequel un orifice d'alimentation en gaz par lequel est introduit un gaz atmosphérique, un orifice d'alimentation en air par lequel est introduit de l'air propre et sec, CDA, et un orifice d'évacuation par lequel est évacué le gaz atmosphérique ou le CDA, sont pratiqués dans l'une parmi la chambre mobile d'unité de traitement (100), la chambre mobile d'unité de gestion (200) et la chambre fixe (300).

9. Système d'enceinte selon la revendication 1, dans lequel, lorsqu'une direction horizontale sur un plan de l'enceinte (1) correspond à l'axe X, une direction verticale sur le plan de l'enceinte (1) correspond à l'axe Y, et une direction verticale de l'enceinte (1) correspond à l'axe Z,
l'unité de traitement (IH) est mobile dans la direction de l'axe X et dans la direction de l'axe Z, et l'unité de gestion (VC) est mobile dans la direction de l'axe Y et dans la direction de l'axe Z,
dans un état dans lequel la chambre mobile d'unité de traitement (100) est déplacée et alignée en fonction d'une coordonnée de l'axe X de la chambre mobile d'unité de gestion (200), et dans lequel la chambre mobile d'unité de gestion (200) est déplacée et alignée en fonction d'une coordonnée de l'axe Y de la chambre mobile d'unité de traitement (100), la chambre mobile d'unité de traitement (100) et la chambre mobile d'unité de gestion (200) entrent en contact étroit l'une avec l'autre lorsque l'une au moins parmi la chambre mobile d'unité de traitement (100) et la chambre mobile d'unité de gestion (200) est déplacée dans la direction de l'axe Z, et
la chambre mobile d'unité de traitement (100) est alignée en fonction de la coordonnée de l'axe Z de la chambre fixe (300), tout en maintenant l'état dans lequel la chambre mobile d'unité de traitement (100) et la chambre mobile d'unité de gestion (200) sont en contact étroit l'une avec l'autre.

10. Système d'enceinte selon la revendication 1, dans lequel, lorsqu'une direction horizontale sur un plan de l'enceinte correspond à l'axe X, une direction verticale sur le plan de l'enceinte correspond à l'axe Y, et la direction verticale de l'enceinte correspond à l'axe Z,
l'unité de traitement (IH) est mobile dans la direction de l'axe X et dans la direction de l'axe Z, et l'unité de gestion (VC) est mobile dans la direction de l'axe Y et dans la direction de l'axe Z, et
dans un état dans lequel la chambre mobile d'unité de traitement (100) est déplacée et alignée en fonction d'une coordonnée de l'axe X de la chambre mobile d'unité de gestion (200) et d'une coordonnée de l'axe Z de la chambre fixe (300), et dans lequel la chambre mobile d'unité de gestion (200) est déplacée et alignée en fonction d'une coordonnée de l'axe Y de la chambre mobile d'unité de traitement (100),
la chambre mobile d'unité de traitement (100) et la chambre mobile d'unité de gestion (200) entrent en contact étroit l'une avec l'autre lorsque la chambre mobile d'unité de gestion (200) se déplace dans la direction de l'axe Z.

11. Système d'enceinte selon la revendication 1, dans lequel l'unité de gestion (VC) disposée dans la chambre mobile d'unité de gestion (200) comprend au moins un dispositif d'inspection visuelle d'un dispositif d'inspection visuelle de maintenance destiné à l'entretien de l'unité de traitement (IH) et un dispositif d'inspection visuelle de contrôle de fonctionnement destiné à contrôler l'état de fonctionnement de l'unité de traitement (IH).
